# EUROPEAN PATENT SPECIFICATION

(11) **EP 2 207 216 B1**
(45) Date of publication and mention of the grant of the patent: **09.07.2014**
(21) Application number: 08836407.0
(22) Date of filing: 01.10.2008
(51) Int. Cl.: H01L 45/00

(54) **CHALCOGENIDE FILM AND MANUFACTURING METHOD THEREOF**
CHALKOGENIDFILM UND VERFAHREN ZU SEINER HERSTELLUNG
FILM DE CHALCOGÉNURE ET SON PROCÉDÉ DE FABRICATION

(30) Priority: 02.10.2007 JP 2007258563
(43) Date of publication of application: 14.07.2010
(73) Proprietor: Ulvac, Inc., Chigasaki-shi Kanagawa 253-8543 (JP)
(72) Inventor: KIKUCHI, Shin, Shizuoka 410-1231 (JP); NISHIOKA, Yutaka, Shizuoka 410-1231 (JP); KIMURA, Isao, Shizuoka 410-1231 (JP); JIMBO, Takehito, Shizuoka 410-1231 (JP); SUU, Koukou, Shizuoka 410-1231 (JP)
(74) Representative: Eisenführ Speiser
(86) International application number: PCT/JP2008/067823
(87) International publication number: WO 2009/044769

(56) References cited:
- JP-A- 2004 241 535
- JP-A- 2006 202 823
- JP-A- 2007 019 475
- JP-A- 2007 165 710
- JP-A- 2008 182 234
- JP-T- 11 510 317
- US-A1- 2006 113 520

## Description

### TECHNICAL FIELD

The present invention relates to a chalcogenide film and a manufacturing method thereof. More particularly, the present invention relates to a chalcogenide film which is favorably used for a recording layer of a high integrity memory capable of operating in a nonvolatile manner such as a phase change memory and which suppresses formation of defects such as cavities or cracks in its interior, and also relates to a manufacturing method of the chalcogenide film.

### BACKGROUND ART

In portable equipment such as mobile phones and personal data assistants, there is a growing need of treating much information such as image data in recent years. Accordingly, as for a storage device, such as nonvolatile device, mounted in the portable equipment, there is a growing need of a high-speed, low-power-consumption, high-capacity, and small.

Among other things, a chalcogen-compound-based variable resistance nonvolatile memory (variable resistance storage device) which changes its resistance value in accordance with its crystalline state attracts attention as a memory capable of being highly integrated and operating in a nonvolatile manner (for example, see Patent Document 1).

This variable resistance nonvolatile memory has a simple structure in which a chalcogenide film functioning as a recording layer is sandwiched between two electrodes. Even at room temperature, the memory can stably maintain a state of storage. Therefore, it is an excellent memory well capable of maintaining stored data over 10 years.

In a conventional variable resistance nonvolatile memory, if its element size is simply made smaller for higher integration, the distance between the adjacent elements is extremely small. For example, if a predetermined voltage is applied to the electrodes on upper and lower sides of a recording layer of a single element in order to cause a phase change in the element, there is a possibility that heat from the lower electrode will have an adverse influence on the adjacent elements.

Therefore, a structure can be conceived in which adjacent elements are separated by a chalcogen compound injected into a hole having a small diameter (referred to as a contact hole). The contact hole is formed in an insulating layer with a low thermal conductivity. The insulating layer is deposited on a substrate. The structure has conventionally been implemented by a method of injecting a chalcogen compound into a contact hole by sputtering.
Patent Document 1: Japanese Patent Application, First Publication No. 2004-348906

US 2006/0113520 A1 discloses a phase change memory semiconductor integrated circuit device using a chalcogenide film that solves a problem that the operation temperature capable of ensuring long time memory retention is low due to low phase change temperature and, at the same time, a problem that power consumption of the device is high since a large current requires a rewrite memory information due to low resistance. A portion of the chalcogenide at the boundary with an underlying electrode comprises a nitride, oxide, or carbide of Ge, Sb, or Zn.

JP 2004-241535 A discloses a resistance varying element that has a first electrode, a dielectric layer, and a chalcogenide recording layer with contact hole formed over them provided on a substrate. The recording layer is sandwiched by the first electrode and a second electrode. A resistance value of the layer is varied by an electrical pulse impressed between the first electrode and the second electrode. A contact layer of ZnS-SiO₂ is formed between the dielectric layer and the recording layer.

However, in the above method of injecting a chalcogen compound into a contact hole by sputtering, if the depth of the hole is approximately double or more the diameter of the contact hole, it is not possible to completely fill the contact hole with the chalcogen compound due to a property of deposition by sputtering. This results in a problem of voids (spaces) being left in its central portion. Formation of voids in the chalcogen compound filling the contact hole increases electrical resistance, and hence leads to poor conduction.

In addition, the chalcogen compound is in a crystalline state with a comparatively small particle size (face centered cubic crystal) at temperatures up to approximately 200°C. However, at higher temperatures than approximately 200°C, the chalcogen compound becomes a crystalline state with coarse particles (hexagonal crystal). Therefore, sputtering causes the chalcogen compound to be exposed to high temperatures, making its particles coarse. The chalcogen compound with the coarse particles shows a significant decrease in its adhesion to the insulating film that forms the contact hole (for example, SiN, SiO₂). Therefore, the chalcogen compound is peeled away from the contact hole. This results in a problem of production of voids in the contact hole, leading to poor conduction.

### DISCLOSURE OF INVENTION

The present invention has been achieved to solve the above problems, and has an object to provide a chalcogenide film which suppresses formation of defects such as cavities or cracks in its interior and also to provide a manufacturing method thereof.

To solve the above problems and achieve the object, the present invention adopts the following.
(1) A chalcogenide film of the present invention is deposited, by sputtering, in a contact hole formed in an insulating layer on a substrate. The chalcogenide film comprising: an underlayer film formed at least on a bottom portion of the contact hole; and a crystal layer made of a chalcogen compound, and formed onto the underlayer film and in the contact hole, wherein the underlayer film is a fine crystal layer made of a chalcogen compound finer than that of the crystal layer, the fine crystal layer is face centered cubic crystal, and the crystal layer is hexagonal crystal.
(2) It is preferable that the underlayer film has a thickness of equal to or greater than 10% and less than or equal to 20% of a depth of the contact hole.
(3) It is preferable that the chalcogen compound include one or more selected from the group consisting of S, Se, and Te.
(4) It is more preferable that the chalcogen compound comprises equal to or more than 30 wt% and less than or equal to 60 wt% of Te, equal to or more than 10 wt% and less than or equal to 70 wt% of Ge, equal to or more than 10 wt% and less than or equal to 40 wt% of Sb, and equal to or more than 10 wt% and less than or equal to 70 wt% of Se, and that the sum total of the amounts of Te, Ge, Sb, and Se be less than or equal to 100 wt%.
(5) A manufacturing method of a chalcogenide film of the present invention is a method of depositing a chalcogenide film, by sputtering, in a contact hole formed in an insulating layer on a substrate. The method comprises: forming an underlayer film on at least a bottom portion of the contact hole while the substrate is maintained at a temperature of less than or equal to 200°C, preferably equal to or greater than 100°C and less than or equal to 200°C; and forming, by sputtering and reflowing, a crystal layer made of a chalcogen compound onto the underlayer film and in the contact hole while the substrate is maintained at a temperature which does not allow a constituent element of the chalcogen compound to volatilize, wherein the underlayer film is a fine crystal layer made of a chalcogen compound finer than that of the crystal layer, the fine crystal layer is face centered cubic crystal, and the crystal layer is hexagonal crystal.
(6) It is preferable that the temperature of the substrate during the formation of the crystal layer be equal to or greater than 250°C, preferably equal to or greater than 300°C, more preferably equal to or greater than 300°C and less than or equal to 400°C.

### ADVANTAGEOUS EFFECTS OF INVENTION

According to the chalcogenide film as set forth in the above (1), with the formation of an underlayer film for a crystal layer composed of a chalcogen compound, it is possible to increase the adhesion of a chalcogenide film to a contact hole.

Moreover, with the formation of an underlayer film from a chalcogen compound with fine crystal particles, the area of the chalcogenide film in contact with the interior wall surface of the contact hole is made large, leading to a significant increase in adhesion of the chalcogenide film to the contact hole. This makes it possible to securely prevent unfavorable situations such as where voids produced in the contact hole through peeling away (removal) of the chalcogenide film from the contact hole cause poor conductivity between the lower electrode and the upper electrode.

In addition, with the increased adhesion of the chalcogenide film to the contact hole, the electrical resistance between the lower electrode and the upper electrode via the chalcogenide film is decreased, thus enabling an increase in electrical conductivity. This makes it possible to implement a semiconductor apparatus having excellent electrical properties, for example, a variable resistance nonvolatile memory.

According to the manufacturing method of a chalcogenide film as set forth in the above (5), with the formation of an underlayer film from a chalcogen compound with a crystal particle size finer than that of a crystal layer, the area of the chalcogenide film in contact with the interior wall surface of the contact hole can be made large. As a result, the adhesion of the chalcogenide film to the contact hole can be significantly increased. This makes it possible to manufacture a chalcogenide film which securely prevents unfavorable situations such as being peeled away (removed) from the contact hole to produce voids in the contact hole, which causes poor conductivity between the lower electrode and the upper electrode.

### BRIEF DESCRIPTION OF THE DRAWINGS

FIG 1 is a cross-sectional view showing a chalcogenide film according to a first embodiment of the present invention.
FIG. 2 is a cross-sectional view showing a chalcogenide film according to a second embodiment outside the scope of the present invention.
FIG. 3A is a cross-sectional view showing a manufacturing method of the chalcogenide film in the first embodiment.
FIG 3B is a cross-sectional view showing the manufacturing method of the chalcogenide film in the first embodiment.
FIG. 3C is a cross-sectional view showing the manufacturing method of the chalcogenide film in the first embodiment.
FIG. 3D is a cross-sectional view showing the manufacturing method of the chalcogenide film in the first embodiment.
FIG. 4A is a cross-sectional view showing a manufacturing method of the chalcogenide film in the second embodiment.
FIG 4B is a cross-sectional view showing the manufacturing method of the chalcogenide film in the second embodiment.
FIG 4C is a cross-sectional view showing the manufacturing method of the chalcogenide film in the second embodiment.
FIG 4D is a cross-sectional view showing the manufacturing method of the chalcogenide film in the second embodiment.

### DESCRIPTION OF THE REFERENCE SYMBOLS

11: substrate
12: insulating film
13: contact hole
14, 24: chalcogenide film
14a, 24a: underlayer film
14b, 24b: crystal layer
15: lower electrode
16: upper electrode

### BEST MODE FOR CARRYING OUT THE INVENTION

Hereunder is a description of the best mode of a chalcogenide film according to the present invention based on the drawings.

The embodiments are specifically described for better understanding of the scope of the invention, and do not limit the invention unless otherwise specified.

### [First embodiment]

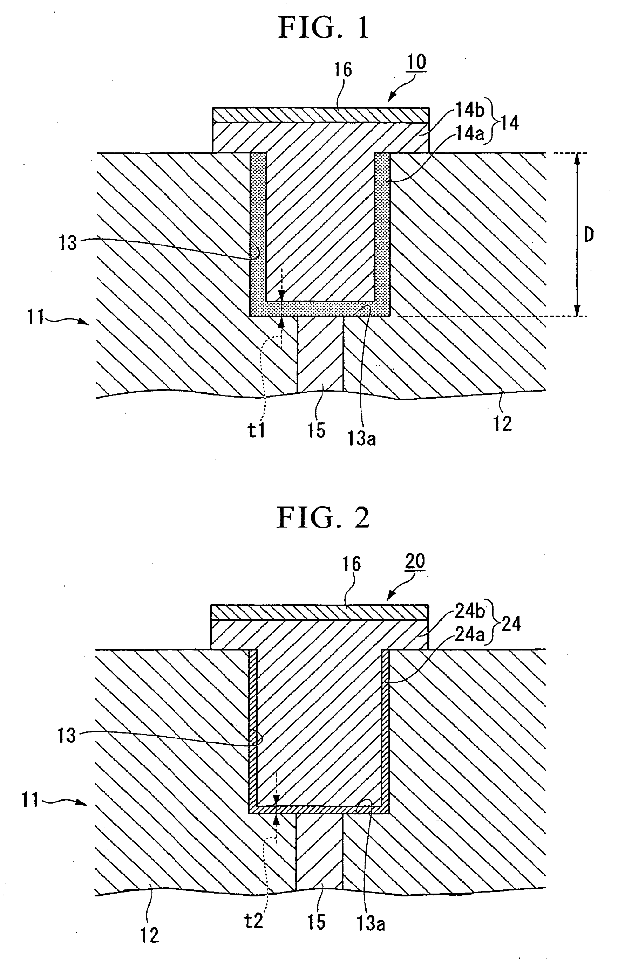

FIG 1 is a cross-sectional view showing a semiconductor apparatus provided with a chalcogenide film according to a first embodiment of the present invention. The semiconductor apparatus 10 is favorably used as a variable resistance nonvolatile memory. The semiconductor apparatus 10 includes: a contact hole 13 formed in an insulating film 12 on a substrate 11; and a chalcogenide film 14 deposited in the contact hole 13. Furthermore, in the semiconductor apparatus 10, there are formed: a lower electrode 15 one end of which is exposed at a bottom portion 13a of the contact hole 13 to be in contact with the chalcogenide film 14; and an upper electrode 16 formed over a top surface of the chalcogenide film 14.

As the substrate 11, for example a silicon wafer or the like can be used. As the insulating film 12, for example a silicon dioxide film which is formed by oxidizing a surface of a silicon wafer, a silicon nitride, or the like can be used.

The chalcogenide film 14 comprises: an underlayer film 14a with a predetermined thickness along an interior surface of the contact hole 13 including at least the bottom portion 13a of the contact hole 13; and a crystal layer 14b over the underlayer film 14a for filling the contact hole 13.

The underlayer film 14a and the crystal layer 14b are both composed of a chalcogen compound. The chalcogen compound composing the underlayer film 14a is made of a fine crystal layer of a chalcogen compound finer than the crystal layer 14b. According to the present invention, the crystal layer 14b is composed of a hexagonal crystal of chalcogen compound, and the underlayer film 14a is composed of a face centered cubic crystal of chalcogen compound whose crystal particle size is smaller than that of the hexagonal crystal of chalcogen compound.

To be more specific, the hexagonal crystal of chalcogen compound forming the crystal layer 14b has an average particle size of approximately 30 to 100 nm. The face centered cubic crystal of chalcogen compound forming the underlayer film 14a has an average particle size of approximately 3 to 10 nm. A manufacturing method of the chalcogenide film 14 with two layers whose crystal structures are different from each other will be described in detail later.

The underlayer film 14a is required to be formed on at least the bottom portion of the contact hole 13, that is, on a surface facing the lower electrode 15. It is more preferable that the underlayer film 14a be formed also on a side surface in a depth direction of the contact hole 13. The underlayer film 14a is required to be formed with a thickness of equal to or more than 10% and less than or equal to 20% of a depth D of the contact hole 13. For example, if the depth D of the contact hole 13 is 100 nm, the underlayer film 14a has a thickness t1 of 10 to 20 nm.

The chalcogen compounds composing the underlayer film 14a and the crystal layer 14b are required to include one or more selected from the group consisting of S, Se, and Te. For example, as the chalcogen compound, a preferable one includes equal to or more than 30 wt% and less than or equal to 60 wt% of Te, equal to or more than 10 wt% and less than or equal to 70 wt% of Ge, equal to or more than 10 wt% and less than or equal to 40 wt% of Sb, and equal to or more than 10 wt% and less than or equal to 70 wt% of Se, in which the sum total of the amounts of Te, Ge, Sb, and Se is less than or equal to 100 wt%.

According to the chalcogenide film 14 of the present embodiment, as a ground for the crystal layer 14b composed of a chalcogen compound with a coarse crystalline particle size, the underlayer film 14a composed of a chalcogen compound with a crystal structure finer than that of the crystal layer 14b. This increases the adhesion of the chalcogenide film 14 to the contact hole 13.

In the case where a contact hole is filled only with a conventional chalcogen compound with a coarse crystalline particle size, for example, a hexagonal crystal of chalcogen compound, the contact area of the particles of the chalcogenide film with the inner wall surface of the contact hole is small. Therefore, the chalcogenide film is sometimes peeled away (removed) from the contact hole. On the other hand, in the chalcogenide film 14 of the present embodiment, the underlayer film 14a is formed from a face centered cubic crystal of chalcogen compound with fine crystal particles, making the contact area of the chalcogenide film 14 with the inner wall surface of the contact hole 13 large. This makes it possible to significantly increase the adhesion of the chalcogenide film 14 to the contact hole 13.

Especially in the case where a silicon dioxide film or a silicon nitride film is used as the insulating film 12, the insulating film 12 has difficulty in its adhesion to the chalcogenide film. However, with the formation of an underlayer film 14a composed of a face centered cubic crystal of chalcogen compound with fine crystal particles, the adhesion of the chalcogenide film 14 to the silicon dioxide film or the silicon nitride film can be made favorable. Therefore, it becomes possible to securely prevent unfavorable situations such as where voids produced in the contact hole 13 through peeling away (removal) of the chalcogenide film 14 from the contact hole 13 cause poor conductivity between the lower electrode 15 and the upper electrode 16.

In addition, with the increased adhesion of the chalcogenide film 14 by forming the underlayer film 14a with a crystal structure finer than that of the crystal layer 14b, the electrical resistance between the lower electrode 15 an the upper electrode 16 via the chalcogenide film 14 is decreased, thus enabling an increase in electrical conductivity. This makes it possible to implement a semiconductor apparatus having excellent electrical properties, for example, a variable resistance nonvolatile memory.

Furthermore, the crystal layer 14b and the underlayer film 14a which constitute the chalcogenide film 14 are formed from chalcogen compounds, although they are different in crystal structure from each other. Therefore, the affinity for and the adhesion to each other are enhanced. As a result, despite its two-layer structure, a tightly-integrated chalcogenide film 14 can be implemented.

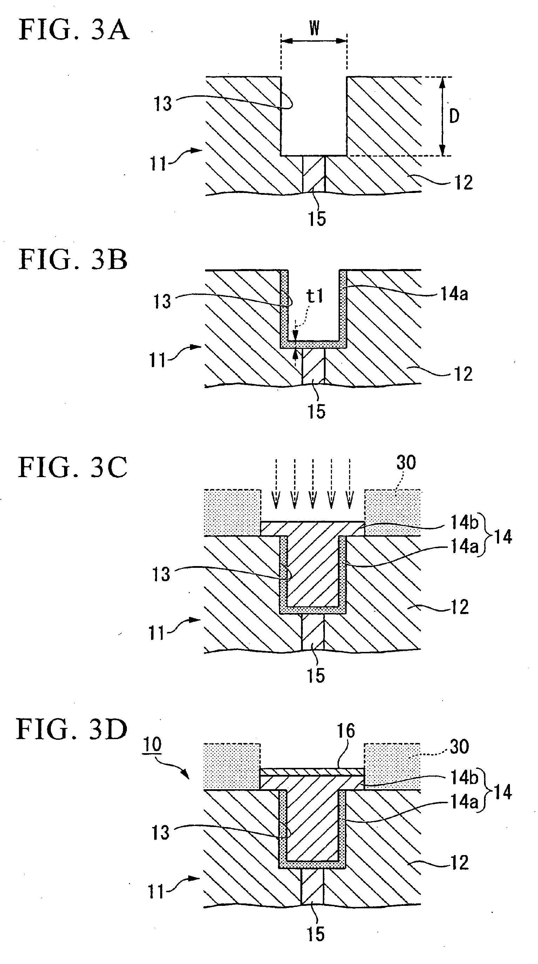

Next is a description of a manufacturing method of the chalcogenide film according to the first embodiment shown in FIG. 1. To manufacture the chalcogenide film with the structure shown in FIG 1, a contact hole 13 and a lower electrode 15 are first formed in an insulating film 12 of a substrate 11, as shown in FIG. 3A. In the contact hole 13, a length of a depth D may be double or more than that of an opening diameter W.

Next, as shown in FIG. 3B, an underlayer film 14a is formed inside the contact hole 13. To form the underlayer film 14a, a resist film 30 with a predetermined pattern is formed around the contact hole 13. Subsequently, the substrate 11 is kept at less than or equal to 200°C, preferably equal to or greater than 100°C and less than or equal to 200°C. Then the chalcogen compound is heated to a range of equal to or greater than 100°C and less than or equal to 200°C, and the underlayer film 14a is deposited on the interior surface of the contact hole 13 by sputtering. In an environment at temperatures of less than or equal to 200°C, chalcogen compounds become a face centered cubic crystal with a crystal particle size smaller than that of a hexagonal crystal of chalcogen compound which composes a crystal layer to be formed in the subsequent step. As a result, the underlayer film 14a composed of a face centered cubic crystal of chalcogen compound is formed on the interior surface of the contact hole 13.

The underlayer film 14a is formed so that the thickness t1 is equal to or greater than 10% and less than or equal to 20% of a depth D of the contact hole 13. For example, if the depth D of the contact hole 13 is 100 nm, the thickness t1 of the underlayer film 14a is formed to be 10 to 20 nm.

Subsequently, as shown in FIG. 3C, a crystal layer 14b is formed onto the underlayer film 14a formed inside the contact hole 13, and also into the contact hole 13. To form the crystal layer 14b, the substrate 11 is kept at equal to or greater than 250°C, preferably equal to or greater than 300°C, more preferably equal to or greater than 300°C and less than or equal to 400°C. Then, the chalcogen compound is heated to a range of equal to or greater than 300°C and less than or equal to 400°C, and the crystal layer 14b is deposited on the interior surface of the contact hole 13 by sputtering.

Chalcogen compounds become a hexagonal crystal structure in an environment at temperatures of equal to or greater than 250°C, and become a more perfect hexagonal crystal structure in an environment at temperatures of equal to or greater than 300°C. Furthermore, heated to equal to or greater than 300°C, the chalcogen compound deposited by sputtering is reflown, and solidly fills the inside of the contact hole 13 so as to cover the underlayer film 14a. In this manner, the reflow of the chalcogen compound makes it unlikely to produce minute spaces in the crystal layer 14b even if the contact hole 13 is a deep hole with the depth D which is double or more than that of the opening diameter W. Therefore, an increase in electrical resistance of the chalcogenide film 14 by voids can be prevented, allowing formation of the chalcogenide film 14 with excellent electrical conductivity.

Furthermore, with the chalcogen compound being heated to less than or equal to 400°C, it is possible to maintain the stoichiometric composition of the chalcogenide film 14 even if a volatile component such as Te is included in the chalcogen compound.

As described above, with the formation of the underlayer film 14a from a chalcogen compound with a crystal particle size finer than that of the crystal layer 14b, the contact area of the chalcogenide film 14 with the interior wall surface of the contact hole 13 becomes large, leading to a significant increase in adhesion of the chalcogenide film 14 to the contact hole 13. This makes it possible to securely prevent unfavorable situations such as where voids produced in the contact hole 13 through peeling away (removal) of the chalcogenide film 14 from the contact hole 13 cause poor conductivity between the lower electrode 15 and the upper electrode 16.

After this, as shown in FIG. 3D, an upper electrode 16 is formed on top of the chalcogenide film 14, and the resist film 30 is removed. Thereby, it is possible to manufacture the semiconductor apparatus 10 provided with the chalcogenide film 14 excellent in electrical properties, for example, a variable resistance nonvolatile memory.

### [Second embodiment]

FIG 2 is a cross-sectional view showing a semiconductor apparatus provided with a chalcogenide film according to a second embodiment outside the scope of the present invention. In the second embodiment, components similar to those of the aforementioned first embodiment are denoted by the same reference symbols, and detailed description thereof is omitted.

In the second embodiment, the chalcogenide film 24 deposited in a contact hole 13 of a semiconductor apparatus 20 comprises: an underlayer film 24a with a predetermined thickness along an interior surface of the contact hole 13 including at least a bottom portion 13a of a contact hole 13; and a crystal layer 24b which is formed over the underlayer film 24a and fills the contact hole 13.

The underlayer film 24a is made from a metal oxide. Especially, it is preferable that the underlayer film 24a be formed from one or more selected from the group consisting of Ta₂O₅, TiO₂, Al₂O₃, and V₂O₅. It is more preferable that, as the metal oxide for forming the underlayer film 24a, one whose crystal particle size is finer than that of a chalcogen compound for forming the crystal layer 24b be used.

The crystal layer 24b is formed from a chalcogen compound such as a hexagonal crystal of chalcogen compound.

The underlayer film 24a is required only to be formed on at least the bottom portion of the contact hole 13, that is, on a surface facing the lower electrode 15. It is more preferable that the underlayer film 24a be formed also on a side surface in a depth direction of the contact hole 13. In the underlayer film 24a, it is preferable that a thickness t2 at the bottom portion of the contact hole 13 be formed to have a thickness of equal to or greater than 0.1 nm and less than or equal to 2 nm. As a result, electrical conductivity between the chalcogenide film 24 and the lower electrode 15 is maintained due to the tunneling current (the quantum tunneling effect), even if the metal oxide forming the underlayer film 24a is an insulating substance.

In the chalcogenide film 24, as an underlayer for the crystal layer 24b composed of a chalcogen compound with a coarse crystalline particle size, the underlayer film 24a is composed of a metal oxide. This increases the adhesion of the chalcogenide film 24 to the contact hole 13.

In the case where a contact hole is filled only with a conventional chalcogen compound with a coarse crystalline particle size, for example, a hexagonal crystal of chalcogen compound, the contact area of the particles of the chalcogenide film with the inner wall surface of the contact hole is small. Therefore, the chalcogenide film is sometimes peeled away (removed) from the contact hole.

On the other hand, in the chalcogenide film 24 of the present embodiment, the underlayer film 24a is formed from a metal oxide, making the area of the chalcogenide film 24 in contact with the inner wall surface of the contact hole 13 large. Therefore, adhesion of the chalcogenide film 24 to the contact hole 13 becomes significantly increased. This makes it possible to securely prevent unfavorable situations such as where voids produced in the contact hole 13 through peeling away (removal) of the chalcogenide film 24 from the contact hole 13 cause poor conductivity between the lower electrode 15 and the upper electrode 16.

In addition, with the increased adhesion of the chalcogenide film 24 by forming the underlayer film 24a formed from a metal oxide, the electrical resistance between the lower electrode 15 an the upper electrode 16 via the chalcogenide film 24 becomes lower, thus enabling an increase in electrical conductivity. This makes it possible to implement a semiconductor apparatus having excellent electrical properties, for example, a variable resistance nonvolatile memory.

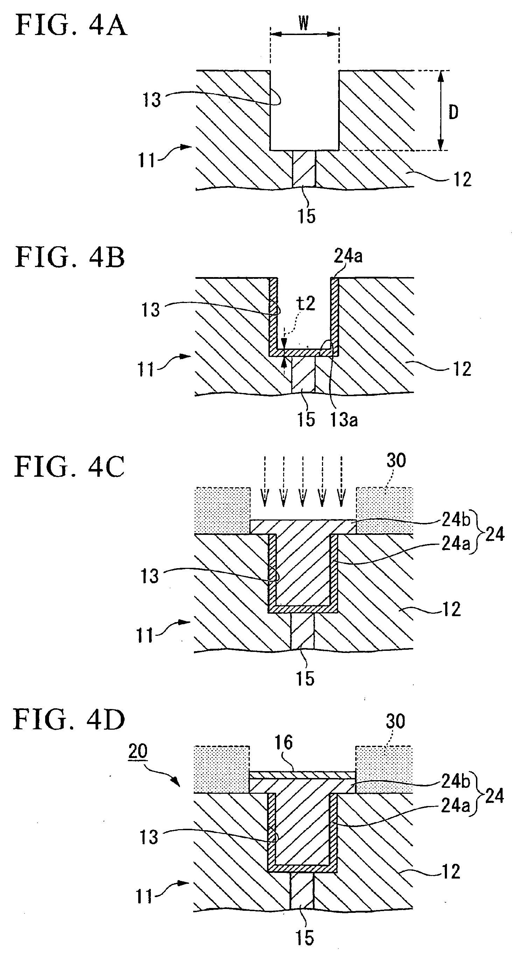

Next is a description of a manufacturing method of the chalcogenide film with the structure shown in FIG. 2. As shown in FIG 4A, a contact hole 13 and a lower electrode 15 are first formed in an insulating film 12 of a substrate 11. In the contact hole 13, a length of a depth D may be double or more than that of an opening diameter W.

Next, as shown in FIG 4B, an underlayer film 24a is formed inside the contact hole 13. To form the underlayer film 24a, a resist film 30 with a predetermined pattern is formed around the contact hole 13. Subsequently, metal oxide(s), for example one or more selected from the group consisting of Ta₂O₅, TiO₂, Al₂O₃, and V₂O₅, are deposited on the interior surface of the contact hole 13 by sputtering. As a result, the underlayer film 24a composed of metal oxide(s) is formed on the interior surface of the contact hole 13. As for the underlayer film 24a, the thickness t2 at least at the bottom portion 13a of contact hole 13 is required to be formed to be equal to or greater than 0.1 nm and less than or equal to 2 nm.

Subsequently, as shown in FIG 4C, a crystal layer 24b is formed onto the underlayer film 24a formed inside the contact hole 13, and also into the contact hole 13. To form the crystal layer 24b, the substrate 11 is kept at equal to or greater than 250°C, preferably equal to or greater than 300°C, more preferably equal to or greater than 300°C and less than or equal to 400°C. Then, the chalcogen compound is heated to a range of equal to or greater than 300°C and less than or equal to 400°C, and the crystal layer 24b is deposited on the interior surface of the contact hole 13 by sputtering.

Heated to temperatures of equal to or greater than 300°C, the chalcogen compound deposited by sputtering is reflown, and solidly fills the inside of the contact hole 13 so as to cover the underlayer film 24a. The reflow makes it unlikely to produce minute spaces in the crystal layer 24b even if the contact hole 13 is a deep hole with the depth D which is double or more than that of the opening diameter W. Therefore, an increase in electrical resistance of the chalcogenide film 24 by voids can be prevented, allowing formation of the chalcogenide film 24 with excellent electrical conductivity.

Furthermore, with the chalcogen compound being heated to less than or equal to 400°C, it is possible to maintain the stoichiometric composition of the chalcogenide film 24 even if a volatile component such as Te is included in the chalcogen compound.

As described above, with the formation of the underlayer film 24a from metal oxide(s), the adhesion of the chalcogenide film 24 to the contact hole 13 is significantly increased. This makes it possible to securely prevent unfavorable situations such as where voids produced in the contact hole 13 through peeling away (removal) of the chalcogenide film 24 from the contact hole 13 cause poor conductivity between the lower electrode 15 and the upper electrode 16.

After this, as shown in FIG. 4D, an upper electrode 16 is formed on top of the chalcogenide film 24, and the resist film 30 is removed. Thereby, it is possible to manufacture the semiconductor apparatus 20 provided with the chalcogenide film 24 excellent in electrical properties, for example, a variable resistance nonvolatile memory.

### EXAMPLES

To verify the advantages of the present invention, results of a tape peel test showing the adhesion of chalcogenide films to a contact hole will be shown below as examples. For the verification, pieces of Scotch (R) Tape (product name; manufactured by Sumitomo 3M Limited) with a size of 1 mm × 10 mm × 1 mm were used. A hundred peel tests were carried out for each sample in which a piece of the tape was adhered to a substrate including a contact hole formed with a chalcogenide film. The percentage of the cases where the chalcogenide film was left without being removed from the contact hole is denoted as a residual percentage (%).

The samples used for the verification are followings. As shown in FIG 1, a two-layered chalcogenide film made of an underlayer film and a crystal layer which are composed of chalcogen compounds different in crystal particle size from each other is denoted as Inventive Example 1. As shown in FIG. 2, two-layered chalcogenide films made of an underlayer film composed of a metal oxide and a crystal layer composed of a chalcogen compound are denoted as Examples 2 to 5 (Ta₂O₅, TiO₂, Al₂O₃, and V₂O₅ are used as the metal oxide, respectively). A single-layered chalcogenide film deposited at a high temperature (400°C) and composed of a hexagonal crystal of chalcogen compound is denoted as Comparative Example (Conventional Example). The underlayer films of Examples 1 to 5 had a thickness of 1 nm. The results of the verification carried out under the above conditions are shown in Table 1.

**Table 1**

| Sample | Residual Percentage (%) |
|---|---|
| Comparative Example (Conventional Example) | 78 |
| Inventive Example 1 (2 layers of chalcogen) | 96 |
| Example 2 (underlayer layer: Ta₂O₅) | 100 |
| Example 3 (underlayer layer: TiO₂) | 95 |
| Example 4 (underlayer layer: Al₂O₃) | 98 |
| Example 5 (underlayer layer: V₂O₅) | 99 |

According to the verification results shown in Table 1, all the chalcogenide films of Examples 1 to 5, which are formed with an underlayer film, have a residual percentage of 95% or greater in the tape test, verifying an extremely high resistance to peeling. On the other hand, the chalcogenide film of Conventional Example, which has a single-layered structure without an underlayer film, has a residual percentage of approximately only 78% in the tape test, showing a resistance to peeling inferior to those of Examples 1 to 5.

### INDUSTRIAL APPLICABILITY

According to the present invention, with the formation of a fine crystal chalcogenide underlayer film for a crystal layer composed of a chalcogen compound with a coarse particle size, it is possible to increase the adhesion of a chalcogenide with a contact hole.

## Claims

1. A chalcogenide film (14) deposited, by sputtering, in a contact hole (13) formed in an insulating layer (12) on a substrate (11), the chalcogenide film (14) comprising:
an underlayer film (14a) formed at least on a bottom portion (13a) of the contact hole (13); and
a crystal layer (14b) made of a chalcogen compound, and formed onto the underlayer film (14a) and in the contact hole (13), wherein
the underlayer film (14a) is a fine crystal layer made of a chalcogen compound finer than that of the crystal layer (14b),
**characterised in that** the fine crystal layer is face centered cubic crystal, and the crystal layer (14b) is hexagonal crystal.

2. The chalcogenide film (14) according to claim 1, wherein
the underlayer film (14a) has a thickness of equal to or greater than 10% and less than or equal to 20% of a depth of the contact hole (13).

3. The chalcogenide film (14) according to claim 1, wherein
the chalcogen compound includes one or more selected from the group consisting of S, Se, and Te.

4. The chalcogenide film (14) according to claim 3, wherein
the chalcogen compound comprises equal to or more than 30 wt% and less than or equal to 60 wt% of Te, equal to or more than 10 wt% and less than or equal to 70 wt% of Ge, equal to or more than 10 wt% and less than or equal to 40 wt% of Sb, and equal to or more than 10 wt% and less than or equal to 70 wt% of Se, and wherein the sum total of the amounts of Te, Ge, Sb, and Se is less than or equal to 100 wt%.

5. A manufacturing method of a chalcogenide film (14), wherein a chalcogenide film (14) is deposited, by sputtering, in a contact hole (13) formed in an insulating layer (12) on a substrate (11), the method comprising:
forming an underlayer film (14a) on at least a bottom portion (13a) of the contact hole (13) while the substrate (11) is maintained at a temperature of less than or equal to 200°C, preferably equal to or greater than 100°C and less than or equal to 200°C; and
forming, by sputtering and reflowing, a crystal layer (14b) made of a chalcogen compound onto the underlayer film (14a) and in the contact hole (13) while the substrate is maintained at a temperature which does not allow a constituent element of the chalcogen compound to volatilize, wherein
the underlayer film (14a) is a fine crystal layer made of a chalcogen compound finer than that of the crystal layer (14b), the fine crystal layer is face centered cubic crystal, and the crystal layer (14b) is hexagonal crystal.

6. The manufacturing method of a chalcogenide film (14) according to claim 5, wherein
the temperature of the substrate (11) during the formation of the crystal layer (14b) is equal to or greater than 250°C, preferably equal to or greater than 300°C, more preferably equal to or greater than 300°C and less than or equal to 400°C.

## Patentansprüche

1. Chalkogenidfilm (14), der, durch Sputtern, in einem Kontaktloch (13), das in einer Isolierschicht (12) auf einem Substrat (11) gebildet ist, abgelagert ist, wobei der Chalkogenidfilm (14) umfasst:
einen Unterschichtfilm (14a), der zumindest auf einem Bodenabschnitt (13a) des Kontaktloches (13) gebildet ist, und
eine Kristallschicht (14b), die aus einer Chalkogenverbindung gemacht ist, und die auf dem Unterschichtfilm (14a) und in dem Kontaktloch (13) gebildet ist, wobei
der Unterschichtfilm (14a) eine Feinkristallschicht ist, die aus einer Chalkogenverbindung gemacht ist, die feiner ist als diejenige der Kristallschicht (14b),
**dadurch gekennzeichnet, dass** die Feinkristallschicht ein kubisch-flächenzentrierter Kristall ist, und dass die Kristallschicht (14b) ein hexagonaler Kristall ist.

2. Chalkogenidfilm (14) nach Anspruch 1, wobei
der Unterschichtfilm (14a) eine Dicke von größer als oder gleich 10 % und kleiner als oder gleich 20 % einer Tiefe des Kontaktlochs (13) aufweist.

3. Chalkogenidfilm (14) nach Anspruch 1, wobei
die Chalkogenverbindung ein oder mehrere ausgewählt aus der Gruppe bestehend aus S, Se und Te beinhaltet.

4. Chalkogenidfilm (14) nach Anspruch 3, wobei
die Chalkogenverbindung gleich oder mehr als 30 Gew.-% und weniger als oder gleich 60 Gew.-% von Te, gleich oder mehr als 10 Gew.-% und weniger als oder gleich 70 Gew.-% von Ge, gleich oder mehr als 10 Gew.-% und weniger als oder gleich 40 Gew.-% von Sb, und gleich oder mehr als 10 Gew.-% und weniger als oder gleich 70 Gew.-% von Se umfasst, und wobei die Gesamtsumme der Mengen von Te, Ge, Sb und Se weniger als oder gleich 100 Gew.-% ist.

5. Herstellungsverfahren eines Chalkogenidfilms (14), wobei ein Chalkogenidfilm (14), durch Sputtern, in einem Kontaktloch (13), das in einer Isolierschicht (12) auf einem Substrat (11) gebildet ist, abgelagert wird, wobei das Verfahren umfasst:
Bilden eines Unterschichtfilms (14a) auf zumindest einem Bodenabschnitt (13a) des Kontaktlochs (13), während das Substrat (11) bei einer Temperatur von weniger als oder gleich 200 °C, bevorzugt gleich oder größer als 100 °C und weniger als oder gleich 200 °C, gehalten wird; und
Bilden, durch Sputtern und Rückfließen, einer Kristallschicht (14b), die aus einer Chalkogenverbindung gemacht ist, auf dem Unterschichtfilm (14a) und in dem Kontaktloch (13), während das Substrat bei einer Temperatur gehalten wird, die es einem konstitutiven Bestandsteil der Chalkogenverbindung nicht erlaubt, sich zu verflüchtigen, wobei
der Unterschichtfilm (14a) eine Feinkristallschicht ist, die aus einer Chalkogenverbindung gemacht ist, die feiner ist als diejenige der Kristallschicht (14b), die Feinkristallschicht ein kubisch-flächenzentrierter Kristall ist, und die Kristallschicht (14b) ein hexagonaler Kristall ist.

6. Herstellungsverfahren eines Chalkogenidfilms (14) nach Anspruch 5, wobei
die Temperatur des Substrats (11) während der Bildung der Kristallschicht (14b) gleich oder größer als 250 °C, bevorzugt gleich oder größer als 300 °C, mehr bevorzugt gleich oder größer als 300 °C und kleiner als oder gleich 400 °C, ist.

## Revendications

1. Film (14) de chalcogénure déposé, par pulvérisation cathodique, dans un trou (13) de contact formé dans une couche (12) isolante sur un substrat (11), le film (14) de chalcogénure comprenant :
un film (14a) sous-jacent formé sur au moins une partie (13a) de fond du trou (13) de contact ; et
une couche (14b) de cristal en un composé chalcogène et formée sur le film (14a) sous-jacent et dans le trou (13) de contact, dans lequel
le film (14a) sous-jacent est une couche de cristal fin en un composé chalcogène plus fin que celui de la couche (14b) de cristal,
**caractérisé en ce que** la couche de cristal est un cristal cubique à face centrée et la couche (14b) de cristal est un cristal hexagonal.

2. Film (14) de chalcogénure suivant la revendication 1, dans lequel
la couche (14a) sous-jacente a une épaisseur supérieure ou égale à 10% et inférieure ou égale à 20% d'une profondeur du trou (13) de contact.

3. Film (14) de chalcogénure suivant la revendication 1, dans lequel
le composé chalcogène comprend un ou plusieurs choisi dans le groupe consistant en S, Se et Te.

4. Film (14) de chalcogénure suivant la revendication 3, dans lequel
le composé chalcogène comprend une quantité supérieure ou égale à 30% en poids et inférieure ou égale à 60% en poids de Te, supérieure ou égale à 10% en poids et inférieure ou égale à 70% en poids de Ge, supérieure ou égale à 10% en poids et inférieure ou égale à 40% en poids de Sb et supérieure ou égale à 10% en poids et inférieure ou égale à 70% en poids de Se, et la somme totale des quantités de Te, Ge, Sb et Se est inférieure ou égale à 100% en poids.

5. Procédé de fabrication d'un film (14) de chalcogénure, dans lequel on dépose un film (14) de chalcogénure, par pulvérisation cathodique, dans un trou (13) de contact formé dans une couche (12) isolante sur un substrat (11), le procédé comprenant :
la formation d'une couche (14a) sous-jacente sur au moins une partie (13a) de fond du trou (13) de contact, alors que le substrat (11) est maintenu à une température inférieure ou égale à 200°C, de préférence supérieure ou égale à 100°C et inférieure ou égale à 200°C ; et
la formation, par pulvérisation cathodique et refusion, d'une couche (14b) de cristal en un composé chalcogène sur le film (14a) sous-jacent et dans le trou (13) de contact, tout en maintenant le substrat à une température qui ne permet pas à un élément constitutif du composé chalcogène de se volatiliser, dans lequel
le film (14a) sous-jacent est une couche de cristal fin en un composé chalcogène plus fin que celui de la couche (14b) de cristal, la couche de cristal fin étant un cristal cubique à face centrée et la couche (14b) de cristal étant un cristal hexagonal.

6. Procédé de fabrication d'un film (14) de chalcogénure suivant la revendication 5, dans lequel
la température du substrat (11) pendant la formation de la couche (14b) de cristal est supérieure ou égale à 250°C, de préférence supérieure ou égale à 300°C, d'une manière encore plus préférée supérieure ou égale à 300°C et inférieure ou égale à 400°C.
